# EUROPEAN PATENT APPLICATION

(11) **EP 4 250 375 A2**
(43) Date of publication of application: **27.09.2023**
(21) Application number: 23186134.5
(22) Date of filing: 17.01.2018
(51) Int. Cl.: H01L 31/0693

(54) **FOUR JUNCTION SOLAR CELL AND SOLAR CELL ASSEMBLIES FOR SPACE APPLICATIONS**

(62) Divisional of application: 21187462.3
(71) Applicant: SolAero Technologies Corp., Albuquerque, NM 87123 (US)
(72) Inventor: DERKACS, Daniel, Albuquerque, 87123 (US); BITTNER, Zachary, Albuquerque, 87123 (US); WHIPPLE, Samantha, Albuquerque, 87123 (US); HAAS, Alexander, Albuquerque, 87123 (US); HART, John, Albuquerque, 87123 (US); MILLER, Nathaniel, Albuquerque, 87123 (US); PATEL, Pravin, Albuquerque, 87123 (US); SHARPS, Paul, Albuquerque, 87123 (US)
(74) Representative: Rummler, Felix

(57) **Abstract**

A four junction space-qualified solar cell designed for operation at AM0 and at a 1 MeV electron equivalent fluence of at least 1 × 10¹⁴ e/cm^{2,} having an upper first solar subcell composed of a semiconductor material having a first band gap; a second solar subcell adjacent to said first solar subcell and composed of a semiconductor material having a second band gap smaller than the first band gap and being lattice matched with the upper first solar subcell; a third solar subcell adjacent to said second solar subcell and composed of a semiconductor material having a third band gap smaller than the second band gap and being lattice matched with the second solar subcell; and a fourth solar subcell adjacent to and lattice mismatched from said third solar subcell and composed of a semiconductor material having a fourth band gap smaller than the third band gap.

## Description

### Field of the Invention

The present disclosure relates to solar cells and the fabrication of solar cells, and more particularly the design and specification of the composition and band gaps of each of the four subcells in a four junction solar cell based on III-V semiconductor compounds in order to achieve improved "end-of-life" performance as may be specified for a predetermined space mission and environment.

### Description of the Related Art

As used in this disclosure, the expression "band gap" of a solar subcell which internally has layers of different band gap shall be defined to mean the band gap of the layer of the solar subcell in which the majority of the charge carriers are generated (such sublayer typically being the p-type base semiconductor layer of the base/emitter photovoltaic junction of such subcell). In the event such layer in turn has sublayers with different band gaps (such as the case of a base layer having a graded composition and more particularly a graded band gap), the sublayer of that solar subcell with the lowest band gap shall be taken as defining the "band gap" of such a subcell. Apart from a solar subcell, more generally in the case of a specifically designated semiconductor region (such as a metamorphic layer), in which that semiconductor region has sublayers or subregions with different band gaps (such as the case of a semiconductor region having a graded composition and more particularly a graded band gap), the sublayer or subregion of that semiconductor region with the lowest band gap shall be taken as defining the "band gap" of that semiconductor region.

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology. Compared to silicon, III-V compound semiconductor multijunction devices have greater energy conversion efficiencies and are generally more radiation resistance, although they tend to be more complex to properly specify and manufacture. Typical commercial III-V compound semiconductor multijunction solar cells have energy efficiencies that exceed 29.5% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of series connected photovoltaic regions with different band gap energies, and accumulating the voltage at a given current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads use increasing amounts of power as they become more sophisticated, and missions and applications anticipated for five, ten, twenty or more years, the power-to-weight (W/kg) and power-to-area (W/m²) ratios and the lifetime efficiency of a solar cell becomes increasingly more important. There is increasing interest not only the amount of power provided per gram of weight and spatial area of the solar cell, not only at initial deployment but over the entire service life of the satellite system, or in terms of a design specification, the amount of residual power provided at the specified "end of life" (EOL), which is affected by the radiation exposure of the solar cell over time in the particular space environment of the solar array, the period of the EOL being different for different missions and applications.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, with each subcell being designed for photons in a specific wavelength band. After passing through a subcell, the photons that are not absorbed and converted to electrical energy propagate to the next subcells, where such photons are intended to be captured and converted to electrical energy.

The individual solar cells or wafers are then disposed in horizontal arrays, with the individual solar cells connected together in an electrical series and/or parallel circuit. The shape and structure of an array, as well as the number of cells it contains, are determined in part by the desired output voltage and current needed by the payload or subcomponents of the payload, the amount of electrical storage capacity (batteries) on the spacecraft, and the power demands of the payloads during different orbital configurations.

A solar cell designed for use in a space vehicle (such as a satellite, space station, or an interplanetary mission vehicle), has a sequence of subcells with compositions and band gaps which have been optimized to achieve maximum energy conversion efficiency for the AM0 solar spectrum in space. The AM0 solar spectrum in space is notably different from the AM1.5 solar spectrum at the surface of the earth, and accordingly terrestrial solar cells are designed with subcell band gaps optimized for the AM1.5 solar spectrum.

The assembly of individual solar cells together with electrical interconnects and the cover glass form a so-called "CIC" (Cell-Interconnected-Cover glass) assembly, which are then typically electrically connected to form an array of series-connected solar cells. The solar cells used in many arrays often have a substantial size; for example, in the case of the single standard substantially "square" solar cell trimmed from a 100 mm wafer with cropped corners, the solar cell can have a side length of seven cm or more.

The radiation hardness of a solar cell is defined as how well the cell performs after exposure to the electron or proton particle radiation which is a characteristic of the space environment. A standard metric is the ratio of the end of life performance (or efficiency) divided by the beginning of life performance (EOLBOL) of the solar cell. The EOL performance is the cell performance parameter after exposure of that test solar cell to a given fluence of electrons or protons (which may be different for different space missions or orbits). The BOL performance is the performance parameter prior to exposure to the particle radiation.

Another important mechanical or structural consideration in the choice of semiconductor layers for a solar cell is the desirability of the adjacent layers of semiconductor materials in the solar cell, i.e. each layer of crystalline semiconductor material that is deposited and grown to form a solar subcell, have similar or substantially similar crystal lattice constants or parameters.

Here again there are trade-offs between including specific elements in the composition of a layer which may result in improved voltage associated with such subcell and therefore potentially a greater power output, and deviation from exact crystal lattice matching with adjoining layers as a consequence of including such elements in the layer which may result in a higher probability of defects, and therefore lower manufacturing yield.

In that connection, it should be noted that there is no strict definition of what is understood to mean two adjacent layers are "lattice matched" or "lattice mismatched". For purposes in this disclosure, "lattice mismatched" refers to two adjacently disposed materials or layers (with thicknesses of greater than 100 nm) having in-plane lattice constants of the materials in their fully relaxed state differing from one another by less than 0.02% in lattice constant. (Applicant notes that this definition is considerably more stringent than that proposed, for example, in U.S. Patent No. 8,962,993, which suggests less than 0.6% lattice constant difference as defining "lattice mismatched" layers).

The conventional wisdom for many years has been that in a monolithic tandem solar cell, "... the desired optical transparency and current conductivity between the top and bottom cells... would be best achieved by lattice matching the top cell material to the bottom cell material. Mismatches in the lattice constants create defects or dislocations in the crystal lattice where recombination centers can occur to cause the loss of photogenerated minority carriers, thus significantly degrading the photovoltaic quality of the device. More specifically, such effects will decrease the open circuit voltage (V_{oc}), short circuit current (J_{sc}), and fill factor (FF), which represents the relationship or balance between current and voltage for effective output" (Jerry M. Olson, U.S. Patent No. 4,667,059, "Current and Lattice Matched Tandem Solar Cell").

As progress has been made toward higher efficiency multijunction solar cells with four or more subcells, nevertheless, "it is conventionally assumed that substantially lattice-matched designs are desirable because they have proven reliability and because they use less semiconductor material than metamorphic solar cells, which require relatively thick buffer layers to accommodate differences in the lattice constants of the various materials" (Rebecca Elizabeth Jones - Albertus et al., U.S. Patent No. 8,962,993).

The present disclosure proposes design features for multijunction solar cells which departs from such conventional wisdom for increasing the efficiency of the multijunction solar cell in converting solar energy (or photons) to electrical energy and optimizing such efficiency at the "end-of-life" period.

EP 3 159 942 A1 discloses a multijunction metamorphic solar cell assembly for space applications and its method of manufacture. The solar cell assembly comprises interconnected first and second discrete semiconductor body subassemblies disposed adjacent and parallel to each other, each semiconductor body subassembly including first top subcell, second (and possibly third) lattice matched middle subcells; a graded interlayer adjacent to the last middle solar subcell; and a bottom solar subcell adjacent to said graded interlayer being lattice mismatched with respect to the last middle solar subcell; wherein the interconnected subassemblies form at least a four junction solar cell by a series connection being formed between the bottom solar subcell in the first semiconductor body and the bottom solar subcell in the second semiconductor body.

P 3 159 943 A1 discloses a multijunction metamorphic solar cell for space applications and its method of manufacture. The solar cell comprises first and second discrete semiconductor body subassemblies, each semiconductor body subassembly including first, second and third lattice matched subcells; a graded interlayer adjacent to the third solar subcell and functioning as a lateral conduction layer; and a fourth solar subcell adjacent to said graded interlayer being lattice mismatched with respect to the third solar subcell; wherein the average band gap of all four cells is greater than 1.44 eV.

US 2016/380142 A1 discloses a multijunction solar cell comprising a first subcell, one or more compensation layers, a metamorphic buffer, and a second subcell with a lattice constant greater than that of the first subcell. The buffer comprises at least three layers with lattice constants greater than that of the second subcell that increase from layer to layer. One of the layers of the buffer layer has a lattice constant greater than that of the first subcell.

### Summary of the disclosure

### Objects of the Disclosure

It is an object of the present disclosure to provide increased photoconversion efficiency in a multijunction solar cell for space applications over the operational life of the photovoltaic power system.

It is another object of the present disclosure to provide in a multijunction solar cell in which the composition of the subcells and their band gaps has been configured to maximize the efficiency of the solar cell at operational conditions of a predetermined high temperature (specifically, in the range of 40 to 70 degrees Centigrade) in deployment in space at AM0 one-sun solar spectrum at a predetermined time after the initial deployment, such time being at least one, five, ten, fifteen or twenty years and not at the time of initial deployment.

It is another object of the present disclosure to provide in a multijunction solar cell in which the composition of the subcells and their band gaps maximizes the efficiency of the solar cell at a predetermined high temperature (in the range of 40 to 70 degrees Centigrade) in deployment in space at AM0 at a predetermined time after the initial deployment, such time being at least one year.

It is another object of the present disclosure to provide in a multijunction solar cell in which the selection of the composition of the subcells and their band gaps maximizes the efficiency of the solar cell at a predetermined high temperature (in the range of 40 to 70 degrees Centigrade) in deployment in space at AM0 at a predetermined time after the initial deployment, such time being at least one year.

It is another object of the present invention to provide a four junction solar cell in which the average band gap of all four cells, i.e. the sum of the four band gaps of each subcell divided by four, is greater than 1.35 eV.

It is another object of the present invention to provide a four junction solar cell in which the lower two subcells are lattice mismatched and in which the current through the bottom subcell is intentionally designed to be substantially greater than current through the top three subcells when measured at the "beginning-of-life" or time of initial deployment.

Some implementations of the present disclosure may incorporate or implement fewer of the aspects and features noted in the foregoing objects.

### Features of the Invention

The scope of the invention is limited to the subject-matter of the appended claims, and relates to a four-junction space-qualified solar cell as defined in claim 1.

All ranges of numerical parameters set forth in this disclosure are to be understood to encompass any and all subranges or "intermediate generalizations" subsumed therein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 1.2, or 1.3 to 1.4, or 1.5 to 1.9 eV.

Briefly, and in general terms, the present disclosure provides a solar cell comprising an upper first solar subcell composed of a semiconductor material having a first band gap; a second solar subcell adjacent to said first solar subcell composed of a semiconductor material having a second band gap smaller than the first band gap and being lattice matched with the upper first solar subcell; a third solar subcell adjacent to said second solar subcell and composed of a semiconductor material having a third band gap smaller than the second band gap and being lattice matched with the second solar subcell; and a fourth solar subcell adjacent to said third solar subcell and composed of a semiconductor material having a fourth band gap smaller than the third band gap and lattice mismatched from the third solar subcell; wherein the fourth subcell has a direct bandgap of greater than 0.75 eV.

In some embodiments, the average band gap of all four subcells (i.e., the sum of the four band gaps of each subcell divided by four) is greater than 1.35 eV.

In some embodiments, the fourth subcell is germanium.

In some embodiments, the second subcell has a band gap of approximately 1.73 eV and the upper first subcell has a band gap of approximately 2.10 eV.

In some embodiments, the upper first solar subcell has a band gap of approximately 2.05 to 2.10 eV, the second solar subcell has a band gap in the range of 1.55 to 1.73 eV; and the third solar subcell has a band gap in the range of 1.15 to 1.41 eV.

In some embodiments, the upper first solar subcell has a band gap of approximately 2.10, the second solar subcell has a band gap of approximately 1.73 eV; and the third solar subcell has a band gap in the range of 1.41 eV.

In some embodiments, the upper first solar subcell has a band gap of approximately 2.10, the second solar subcell has a band gap of approximately 1.65 eV; and the third solar subcell has a band gap of 1.3 eV.

In some embodiments, the upper first solar subcell has a band gap of approximately 2.05, the second solar subcell has a band gap of approximately 1.55 eV; and the third solar subcell has a band gap of 1.2 eV.

In some embodiments, the first solar subcell has a band gap of 2.05 eV.

In some embodiments, the band gap of the third solar subcell is less than 1.41 eV, and greater than that of the fourth subcell.

In some embodiments, the third solar subcell has a band gap in the range of 1.15 to 1.35 eV.

In some embodiments, the third solar subcell has a band gap in the range of 1.1 to 1.2 eV.

In some embodiments, the third solar subcell has a band gap of approximately 1.2 eV.

In some embodiments, the upper first subcell is composed of indium gallium aluminum phosphide; the second solar subcell includes an emitter layer composed of indium gallium phosphide or aluminum indium gallium arsenide, and a base layer composed of aluminum indium gallium arsenide; the third solar subcell is composed of indium gallium arsenide; and the fourth subcell is composed of germanium.

In some embodiments, there further comprises a distributed Bragg reflector (DBR) layer adjacent to and between the third and the fourth solar subcells and arranged so that light can enter and pass through the third solar subcell and at least a portion of which can be reflected back into the third solar subcell by the DBR layer.

In some embodiments, the distributed Bragg reflector layer is composed of a plurality of alternating layers of lattice matched materials with discontinuities in their respective indices of refraction.

In some embodiments, the difference in refractive indices between alternating layers is maximized in order to minimize the number of periods required to achieve a given reflectivity, and the thickness and refractive index of each period determines the stop band and its limiting wavelength.

In some embodiments, the DBR layer includes a first DBR layer composed of a plurality of p type In_{z}AlₓGa_{1-x-z}As sublayers, and a second DBR layer disposed over the first DBR layer and composed of a plurality of p type In_{w}Al_{y}Ga_{1-y-w}As sublayers, where 0 < w < 1, 0 < x < 1, 0 < y < 1, 0 < z < 1 and y is greater than x, so that the first and second DBR layers are compositionally different, thereby increasing the reflection bandwidth of the DBR layer.

In some embodiments, the selection of the composition of the subcells and their band gaps maximizes the efficiency at high temperature (in the range of 40 to 70 degrees Centigrade) in deployment in space at a predetermined time after the initial deployment (referred to as the beginning-of-life or (BOL), such predetermined time being referred to as the end-of-life (EOL) and being at least five years, and the average band gap of all four cells greater than 1.35 eV.

In another aspect, the present disclosure provides a four junction solar cell comprising an upper first solar subcell composed of a semiconductor material having a first band gap; a second solar subcell adjacent to said first solar subcell and composed of a semiconductor material having a second band gap smaller than the first band gap and being lattice matched with the upper first solar subcell; a third solar subcell adjacent to said second solar subcell and composed of a semiconductor material having a third band gap smaller than the second band gap and being lattice matched with the second solar subcell; and a fourth solar subcell adjacent to said third solar subcell and composed of a semiconductor material having a fourth band gap smaller than the third band gap; wherein the average band gap of all four subcells (i.e., the sum of the four band gaps of each subcell divided by four) is greater than 1.35 eV.

In another aspect, the present disclosure provides a four-junction space-qualified solar cell designed for operation at AM0 and at a 1 MeV electron equivalent fluence of at least 1 × 10¹⁴ e/cm², the solar cell comprising subcells, wherein a combination of compositions and band gaps of the subcells is designed to maximize efficiency of the solar cell at a predetermined time, after initial deployment, when the solar cell is deployed in space at AM0 and at an operational temperature in the range of 40 to 70 degrees Centigrade, the predetermined time being at least five years and referred to as the end-of-life (EOL), the solar cell comprising: an upper first solar subcell composed of indium gallium aluminum phosphide and having a first band gap in the range of 2.0 to 2.15 eV attached to the glass supporting member with a transparent adhesive; a second solar subcell adjacent to said first solar subcell and including an emitter layer composed of indium gallium phosphide or aluminum indium gallium arsenide, and a base layer composed of aluminum indium gallium arsenide and having a second band gap in the range of approximately 1.55 to 1.8 eV and being lattice matched with the upper first solar subcell, wherein the emitter and base layers of the second solar subcell form a photoelectric junction; a third solar subcell adjacent to said second solar subcell and composed of indium gallium arsenide and having a third band gap of 1.41 eV or less and being lattice matched with the second solar subcell; and a fourth solar subcell adjacent to said third solar subcell and lattice mismatched therefrom and composed of germanium and having a fourth band gap of approximately 0.67 eV; wherein the average band gap of all four subcells is greater than 1.35 eV.

In some embodiments, the top or upper first subcell is composed of a base layer of (InₓGa₁₋ₓ)_{1-y}Al_{y}P where x is 0.505, and y is 0.142, corresponding to a band gap of 2.10 eV, and an emitter layer of (InₓGa₁₋ₓ)_{-y}Al_{y}P where x is 0.505, and y is 0.107, corresponding to a band gap of 2.05 eV.

In some embodiments, there further comprises an intermediate layer disposed between the third subcell and the fourth subcell wherein the intermediate layer is compositionally graded to lattice match the third solar subcell on one side and the fourth solar subcell on the other side and is composed of any of the As, P, N, Sb based III-V compound semiconductors subject to the constraints of having the in-plane lattice parameter greater than or equal to that of the third solar subcell and less than or equal to that of the lower fourth solar subcell, and having a band gap energy greater than that of the fourth solar subcell.

In some embodiments, there further comprises an intermediate layer disposed between the third subcell and the fourth subcell wherein the intermediate layer is compositionally step-graded with between one and four steps to lattice match the fourth solar subcell on one side and composed of InₓGa₁₋ₓAs or (InₓGa₁₋ₓ)_{y}Al_{1-y}As with 0 < x < 1, 0 < y < 1, and x and y selected such that the band gap remains in the range of 1.15 to 1.41 eV throughout its thickness.

In some embodiments, the intermediate layer has a constant band gap in the range of 1.15 to 1.41 eV, or 1.2 to 1.35 eV, or 1.25 to 1.30 eV.

In some embodiments, either (i) the emitter layer; or (ii) the base layer and emitter layer of the upper first subcell have a different lattice constant from the lattice constant of the second subcell.

In some embodiments, each subcell includes an emitter region and a base region, and one or more of the subcells have a base region having a gradation in doping that increases exponentially from 1 × 10¹⁵ atoms per cubic centimeter adjacent the p-n junction to 4 × 10¹⁸ atoms per cubic centimeter adjacent to the adjoining layer at the rear of the base, and an emitter region having a gradation in doping that decreases from approximately 5 × 10¹⁸ per cubic centimeter in the region immediately adjacent the adjoining layer to 5 × 10¹⁷ per cubic centimeter in the region adjacent to the p-n junction.

In some embodiments, at least one of the upper sublayers of the graded interlayer has a larger lattice constant than the adjacent layers to the upper sublayer disposed above the grading interlayer.

In some embodiments, the difference in lattice constant between the adjacent third and fourth subcells is in the range of 0.1 to 0.2 Angstroms.

In some embodiments, it further comprises a first threading dislocation inhibition layer having a thickness in the range of 0.10 to 1.0 microns and disposed over said second solar subcell.

In some embodiments, it further comprises a second threading dislocation inhibition layer having a thickness in the range of 0.10 to 1.0 micron and composed of InGa(Al)P, the second threading dislocation inhibition layer being disposed over and directly adjacent to said grading interlayer for reducing the propagation of threading dislocations, said second threading dislocation inhibition layer having a composition different from a composition of the first threading dislocation inhibition layer.

In some embodiments, it further comprises: (a) a ceria doped borosilicate glass supporting member that is 3 to 6 mils in thickness attached to the upper first solar subcell by a transparent adhesive; (b) a plurality of interconnects each composed of a silver-plated nickel-cobalt ferrous alloy material, each interconnect welded to a respective bonding pad on each solar cell assembly to electrically connect the adjacent solar cell assemblies of the array in a series electrical circuit; and (c) an aluminum honeycomb panel having a carbon composite face sheet and having a coefficient of thermal expansion (CTE) that substantially matches the Ge layer of the fourth solar subcell in each solar cell assembly mounted thereon.

In another aspect, the present disclosure provides a method for fabricating a four-junction space-qualified solar cell designed for operation at AM0 and at a 1 MeV electron equivalent fluence of at least 1 × 10¹⁴ e/cm², the solar cell comprising subcells, wherein a combination of compositions and band gaps of the subcells is designed to maximize efficiency of the solar cell as a predetermined time, after initial deployment, when the solar cell is deployed in space at AM0 and at an operational temperature in the range of 40 to 70 degrees Centigrade, the predetermined time being at least five years and referred to as the end-of-life (EOL), comprising: providing a growth substrate; forming a first solar subcell over or in the growth substrate; growing a sequence of layers of semiconductor material using a disposition process to form a solar cell comprising a plurality of subcells including a third subcell disposed over the growth substrate and having a band gap in the range of 1.15 to 1.41 eV, a second subcell disposed over and lattice matched to the third subcell and having a band gap in the range of approximately 1.55 to 1.8 eV and an upper subcell disposed over and lattice matched to the second middle subcell and having a band gap in the range of 2.05 to 2.10 eV, wherein the average band gap of all four subcells is greater than 1.35 eV.

In another aspect, the present disclosure provides a method of manufacturing a four junction solar cell comprising providing a germanium substrate; growing on the germanium substrate a sequence of layers of semiconductor material using a semiconductor deposition process to form a solar cell comprising a plurality of subcells including a third subcell disposed over the germanium substrate and having a band gap of 1.41 eV or less, a second subcell disposed over the third subcell and having a band gap in the range of approximately 1.55 to 1.8 eV and an upper first subcell disposed over the second subcell and having a band gap in the range of 2.0 to 2.15 eV.

In some embodiments, additional layer(s) may be added or deleted in the cell structure without departing from the scope of the present disclosure.

Some implementations of the present disclosure may incorporate or implement fewer of the aspects and features noted in the foregoing summaries.

Reference throughout this specification to "one embodiment" or "an embodiment" means that a particular feature, structure, or characteristic described in connection with the embodiment is included in at least one embodiment of the present disclosure. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### Brief description of the drawings

The invention will be better and more fully appreciated by reference to the following detailed description when considered in conjunction with the accompanying drawings, wherein:
FIG. 1 is a graph representing the BOL value of the parameter E_{g}/q - V_{oc} at 28° C plotted against the band gap of certain binary materials defined along the x-axis;
FIG. 2 is a cross-sectional view of the solar cell of a first embodiment of a four junction solar cell after several stages of fabrication including the deposition of certain semiconductor layers on the growth substrate up to the contact layer, according to the present disclosure;
FIG. 3 is a graph of the doping profile in the base and emitter layers of a subcell in the solar cell according to the present disclosure;
FIG. 4A is a cross-sectional view of a second embodiment of a four junction solar cell after several stages of fabrication including the growth of certain semiconductor layers on the growth substrate up to the contact layer, according to the present disclosure;
FIG. 4B is a cross-sectional view of a third embodiment of a four junction solar cell after several stages of fabrication including the growth of certain semiconductor layers on the growth substrate up to the contact layer, according to the present disclosure;
FIG. 5 is a cross-sectional view of a fourth embodiment of a four junction solar cell after several stages of fabrication including the growth of certain semiconductor layers on the growth substrate up to the contact layer, according to the present disclosure;
FIG. 6 is a cross-sectional view of the solar cell of the present disclosure as implemented in a CIC and mounted on a panel;
FIG. 7 is a graph representing the band gap of certain binary materials and their lattice constants; and
FIG. 8 is an enlargement of a portion of the graph of FIG. 7 illustrating different compounds of GaInAs and GaInP with different proportions of gallium and indium, and the location of specific compounds of the graph.

### Description of the preferred embodiment

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells are disclosed in related applications of the applicant. Some, many or all of such features may be included in the structures and processes associated with the "upright" solar cells of the present disclosure. However, more particularly, the present disclosure is directed to the fabrication of a multijunction solar cell grown on a single growth substrate, including in one embodiment the two lower subcells i.e. the fourth and third subcells being lattice mismatched. More specifically, however, in some embodiments, the present disclosure relates to four junction solar cells with direct band gaps in the range of 2.0 to 2.15 eV (or higher) for the upper first subcell, and (i) 1.65 to 1.8 eV, and (ii) 1.41 eV or less for the second and third subcells, and 0.6 to 0.8 eV indirect bandgaps, for the bottom fourth subcell, respectively.

The present disclosure provides an unconventional four junction design (with three grown lattice matched subcells, which are lattice mismatched to the Ge substrate) that leads to a surprising significant performance improvement over that of traditional three junction solar cell on Ge despite the substantial current mismatch present between the top three junctions and the bottom Ge junction, i.e. the fourth subcell. This performance gain is especially realized at high temperature and after high exposure to space radiation by the proposal of incorporating high band gap semiconductors that are inherently more resistant to radiation and temperature, thus specifically addressing the problem of ensuring continues adequate efficiency and power output at the "end-of-life".

Another way of characterizing the present disclosure is that in some embodiments of a four junction solar cell, the average band gap of all four subcells (i.e., the sum of the four band gaps of each subcell divided by 4) is greater than 1.35 eV, wherein the band gap of a solar subcell is the lowest band gap material used in that subcell
In some embodiments, the fourth subcell is germanium, while in other embodiments the fourth subcell is InGaAs, GaAsSb, InAsP, InAlAs, or SiGeSn, InGaAsN, InGaAsNSb, InGaAsNBi, InGaAsNSbBi, InGaSbN, InGaBiN. InGaSbBiN or other III-V or II-VI compound semiconductor material.

Another descriptive aspect of the present disclosure is to characterize the fourth subcell as having a direct band gap of greater than 0.75 eV.

The indirect band gap of germanium at room temperature is about 0.66 eV, while the direct band gap of germanium at room temperature is 0.8 eV. Those skilled in the art will normally refer to the "band gap" of germanium as 0.67 eV, since it is lower than the direct band gap value of 0.8 eV.

The recitation that "the fourth subcell has a direct band gap of greater than 0.75 eV" is therefore expressly meant to include germanium as a possible semiconductor for the fourth subcell, although other semiconductor material can be used as well.

More specifically, the present disclosure intends to provide a relatively simple and reproducible technique that does not employ inverted processing associated with inverted metamorphic multijunction solar cells, and is suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

As suggested above, incremental improvements in the design of multijunction solar cells are made in view of a variety of new space missions and application requirements. Moreover, although such improvements may be relatively minute quantitative modifications in the composition or band gap of certain subcells, as we noted above, such minute parametric changes (such as in the specific band gaps of the upper first subcell, or of the third subcell) provide substantial improvements in efficiency that specifically address the "problems" that have been identified associated with the existing current commercial multijunction solar cells, and provide a "solution" that represents an "inventive step" in the design process.

Thus, in addition to the characterizing feature that the third and fourth solar subcells are not necessarily lattice matched, we explicitly recite in the section "Features of the Invention" above that the fourth solar subcell is "lattice mismatched" from the third solar subcell, and that a variety of different band gap specifications associated with different embodiments of the solar cell of the present disclosure. Additional characterizing features are set forth in the claims hereunder.

One aspect of the present disclosure relates to the use of aluminum in the active layers of the upper subcells in a multijunction solar cell. The effects of increasing amounts of aluminum as a constituent element in an active layer of a subcell affects the photovoltaic device performance. One measure of the "quality" or "goodness" of a solar cell junction is the difference between the band gap of the semiconductor material in that subcell or junction and the V_{oc}, or open circuit voltage, of that same junction. The smaller the difference, the higher the V_{oc} of the solar cell junction relative to the band gap, and the better the performance of the device. V_{oc} is very sensitive to semiconductor material quality, so the smaller the E_{g}/q - V_{oc} of a device, the higher the quality of the material in that device. There is a theoretical limit to this difference, known as the Shockley-Queisser limit. That is the best that a solar cell junction can be under a given concentration of light at a given temperature.

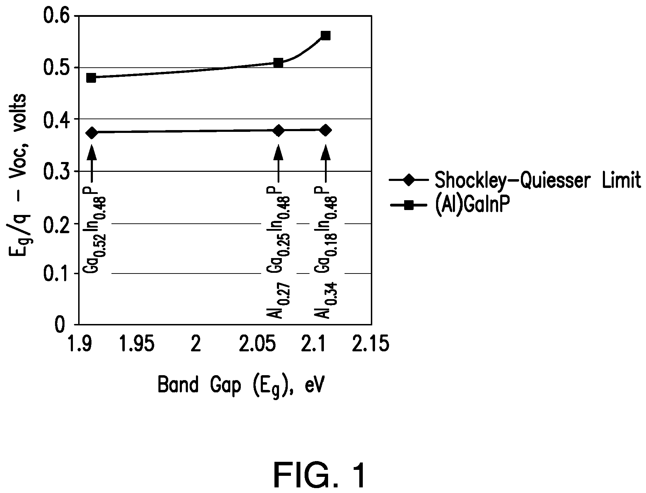

The experimental data obtained for single junction (Al)GaInP solar cells indicates that increasing the Al content of the junction leads to a larger V_{oc} - E_{g}/q difference, indicating that the material quality of the junction decreases with increasing Al content. FIG. 1 shows this effect. The three compositions cited in the Figure are all lattice matched to GaAs, but have differing Al composition. Adding Al increases the band gap of the junction, but in so doing also increases V_{oc} - E_{g}/q. Hence, we draw the conclusion that adding Al to a semiconductor material degrades that material such that a solar cell device made out of that material does not perform relatively as well as a junction with less Al.

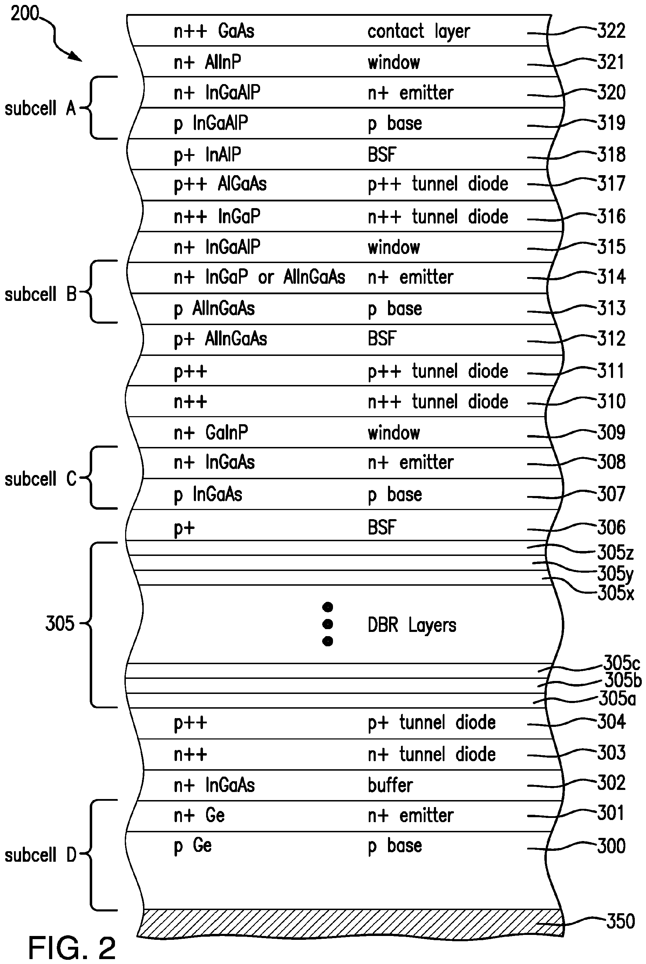

Turning to the multijunction solar cell device of the present disclosure, FIG. 2 is a cross-sectional view of a first embodiment of a four junction solar cell 400 after several stages of fabrication including the growth of certain semiconductor layers on the growth substrate up to the contact layer 322 according to the present disclosure.

As shown in the illustrated example of FIG. 2, the bottom fourth subcell D includes a growth substrate 300 formed of p-type germanium ("Ge") which also serves as a base layer. A back metal contact pad 350 formed on the bottom of base layer 300 provides electrical contact to the multijunction solar cell 200. The bottom subcell D, further includes, for example, a highly doped n-type Ge emitter layer 301, and an n-type indium gallium arsenide ("InGaAs") nucleation layer 302. The nucleation layer is deposited over the base layer, and the emitter layer is formed in the substrate by diffusion of dopants into the Ge substrate, thereby forming the n-type Ge layer 301. Heavily doped p-type aluminum indium gallium arsenide ("AlGaAs") and heavily doped n-type gallium arsenide ("GaAs") tunneling junction layers 304, 303 may be deposited over the nucleation layer to provide a low resistance pathway between the bottom fourth subcell and the third subcell.

In some embodiments, Distributed Bragg reflector (DBR) layers 305 are then grown adjacent to and between the tunnel diode 303, 304 of the bottom fourth subcell D and the third solar subcell C. The DBR layers 305 are arranged so that light can enter and pass through the third solar subcell C and at least a portion of which can be reflected back into the third solar subcell C by the DBR layers 305. In the embodiment depicted in FIG. 2, the distributed Bragg reflector (DBR) layers 305 are specifically located between the third solar subcell C and tunnel diode layers 304, 303; in other embodiments, the distributed Bragg reflector (DBR) layers may be located between tunnel diode layers 304/303 and buffer layer 302.

For some embodiments, distributed Bragg reflector (DBR) layers 305 can be composed of a plurality of alternating layers 305a through 305z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 305a through 305z includes a first DBR layer composed of a plurality of p type In_{z}AlₓGa_{1-x-z}As layers, and a second DBR layer disposed over the first DBR layer and composed of a plurality of p type In_{w}Al_{y}Ga_{1-y-w}As layers, 0 < w < 1, 0 < x < 1, 0 < y < 1, 0 < z < 1, and where y is greater than x.

Although the present disclosure depicts the DBR layer 305 situated between the third and the fourth subcell, in other embodiments, DBR layers may be situated between the first and second subcells, and/or between the second and the third subcells, and/or between the third and the fourth subcells.

In the illustrated example of FIG. 2, the third subcell C includes a highly doped p-type aluminum indium gallium arsenide ("AlInGaAs") back surface field ("BSF") layer 306, a p-type InGaAs base layer 307, a highly doped n-type indium gallium arsenide ("InGaAs") emitter layer 308 and a highly doped n-type indium aluminum phosphide ("AlInP₂") or indium gallium phosphide ("GaInP") window layer 309. The InGaAs base layer 307 of the subcell C can include, for example, approximately 1.5% In. Other compositions may be used as well. The base layer 307 is formed over the BSF layer 306 after the BSF layer is deposited over the DBR layers 305.

The window layer 309 is deposited on the emitter layer 308 of the third subcell C. The window layer 309 in the third subcell C also helps reduce the recombination loss and improves passivation of the cell surface of the underlying junctions. Before depositing the layers of the subcell B, heavily doped n-type InGaP and p-type AlGaAs (or other suitable compositions) tunneling junction layers 310, 311 may be deposited over the subcell C.

The second subcell B includes a highly doped p-type aluminum indium gallium arsenide ("AlInGaAs") back surface field ("BSF") layer 312, a p-type AlInGaAs base layer 313, a highly doped n-type indium gallium phosphide ("InGaP₂") or AlInGaAs layer 314 and a highly doped n-type indium gallium aluminum phosphide ("AlGaAlP") window layer 315.

The InGaP emitter layer 314 of the second subcell B can include, for example, approximately 50% In. Other compositions may be used as well.

Before depositing the layers of the upper first subcell A, heavily doped n-type InGaP and p-type AlGaAs tunneling junction layers 316, 317 may be deposited over the second subcell B.

In the illustrated example, the upper first subcell A includes a highly doped p-type indium aluminum phosphide ("InAlP₂") BSF layer 318, a p-type InGaAlP base layer 319, a highly doped n-type InGaAlP emitter layer 320 and a highly doped n-type InAlP₂ window layer 321. The base layer 319 of the upper first subcell A is deposited over the BSF layer 318 after the BSF layer 318 is formed.

After the cap or contact layer 322 is deposited, the grid lines are formed via evaporation and lithographically patterned and deposited over the cap or contact layer 322.

In some embodiments, at least the base of at least one of the first, second or third solar subcells has a graded doping, i.e., the level of doping varies from one surface to the other throughout the thickness of the base layer. In some embodiments, the gradation in doping is exponential. In some embodiments, the gradation in doping is incremental and monotonic.

In some embodiments, the emitter of at least one of the first, second or third solar subcells also has a graded doping, i.e., the level of doping varies from one surface to the other throughout the thickness of the emitter layer. In some embodiments, the gradation in doping is linear or monotonically decreasing.

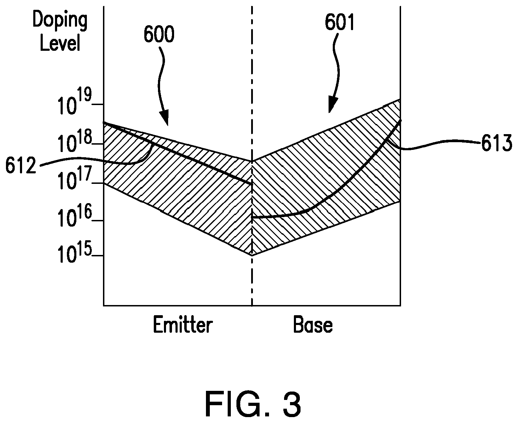

As a specific example, the doping profile of the emitter and base layers may be illustrated in FIG. 3, which depicts the amount of doping in the emitter region and the base region of a subcell. N-type dopants include silicon, selenium, sulfur, germanium or tin. P-type dopants include silicon, zinc, chromium, or germanium.

In the example of Figure 3, in some embodiments, one or more of the subcells have a base region having a gradation in doping that increases from a value in the range of 1 × 10¹⁵ to 1 × 10¹⁸ free carriers per cubic centimeter adjacent the p-n junction to a value in the range of 1 × 10¹⁶ to 4 × 10¹⁸ free carriers per cubic centimeter adjacent to the adjoining layer at the rear of the base, and an emitter region having a gradation in doping that decreases from a value in the range of approximately 5 × 10¹⁸ to 1 × 10¹⁷ free carriers per cubic centimeter in the region immediately adjacent the adjoining layer to a value in the range of 5 × 10¹⁵ to 1 × 10¹⁸ free carriers per cubic centimeter in the region adjacent to the p-n junction.

The heavy lines 612 and 613 shown in Figure 3 illustrates one embodiment of the base doping having an exponential gradation, and the emitter doping being linear.

Thus, the doping level throughout the thickness of the base layer may be exponentially graded from the range of 1 × 10¹⁶ free carriers per cubic centimeter to 1 × 10¹⁸ free carriers per cubic centimeter, as represented by the curve 613 depicted in the Figure.

Similarly, the doping level throughout the thickness of the emitter layer may decline linearly from 5 × 10¹⁸ free carriers per cubic centimeter to 5 × 10¹⁷ free carriers per cubic centimeter as represented by the curve 612 depicted in the Figure.

The absolute value of the collection field generated by an exponential doping gradient exp [-x/λ] is given by the constant electric field of magnitude E = kT/q(1/λ))(exp[-*x*_{b}/λ]), where k is the Boltzman constant, T is the absolute temperature in degrees Kelvin, q is the absolute value of electronic change, and λ is a parameter characteristic of the doping decay.

The efficacy of an embodiment of the doping arrangement present disclosure has been demonstrated in a test solar cell which incorporated an exponential doping profile in the three micron thick base layer a subcell, according to one embodiment.

The exponential doping profile taught by one embodiment of the present disclosure produces a constant field in the doped region. In the particular multijunction solar cell materials and structure of the present disclosure, the bottom subcell has the smallest short circuit current among all the subcells. Since in a multijunction solar cell, the individual subcells are stacked and form a series circuit, the total current flow in the entire solar cell is therefore limited by the smallest current produced in any of the subcells. Thus, by increasing the short circuit current in the bottom cell, the current more closely approximates that of the higher subcells, and the overall efficiency of the solar cell is increased as well. In a multijunction solar cell with approximately efficiency, the implementation of the present doping arrangement would thereby increase efficiency. In addition to an increase in efficiency, the collection field created by the exponential doping profile will enhance the radiation hardness of the solar cell, which is important for spacecraft applications.

Although the exponentially doped profile is the doping design which has been implemented and verified, other doping profiles may give rise to a linear varying collection field which may offer yet other advantages. For example, another doping profile may produce a linear field in the doped region which would be advantageous for both minority carrier collection and for radiation hardness at the end-of-life (EOL) of the solar cell. Such other doping profiles in one or more base layers are within the scope of the present disclosure.

The doping profile depicted herein are merely illustrative, and other more complex profiles may be utilized as would be apparent to those skilled in the art without departing from the scope of the present invention.

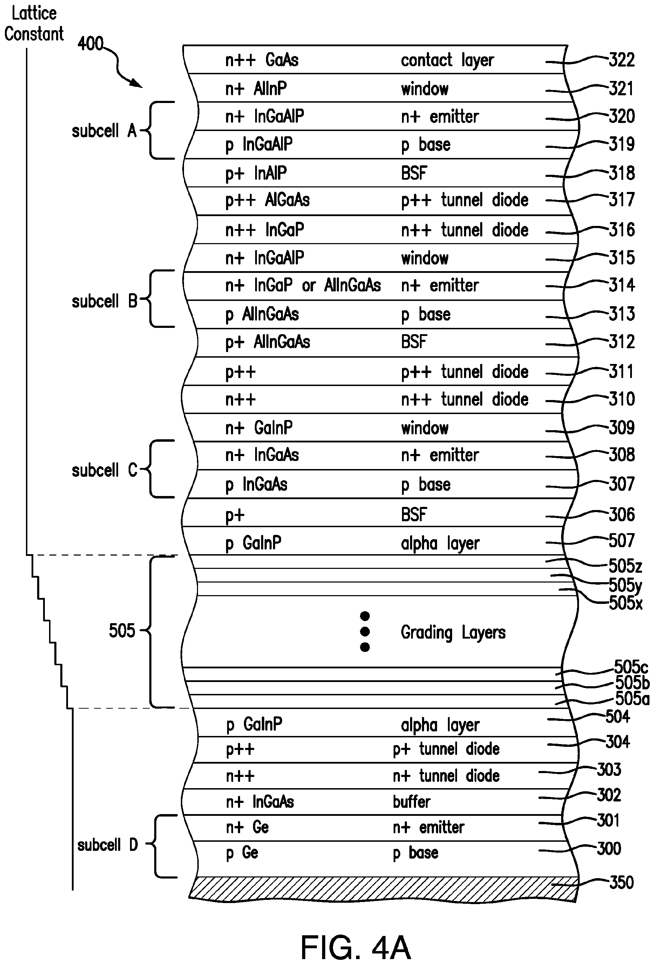

FIG. 4A is a cross-sectional view of a second embodiment of a four junction solar cell 400 after several stages of fabrication including the growth of certain semiconductor layers on the growth substrate up to the contact layer 322, with various subcells being similar to the structure described and depicted in FIG. 2. In the interest of brevity, the description of layers 350, 300 to 304, and 306 through 322 will not be repeated here.

In the embodiment depicted in FIG. 4A, an intermediate graded interlayer 505, comprising in one embodiment step-graded sublayers 505a through 505z, is disposed over the tunnel diode layer 304. In particular, the graded interlayer provides a transition in lattice constant from the lattice constant of the substrate to the larger lattice constant of the third and upper subcells.

A first "alpha" or threading dislocation inhibition layer 504, preferably composed of p-type InGaP, is deposited over the tunnel diode 303/304, to a thickness of from 0.10 to about 1.0 micron. Such an alpha layer is intended to prevent threading dislocations from propagating, either opposite to the direction of growth into the bottom fourth subcell D, or in the direction of growth into the third subcell C, and is more particularly described in U.S. Patent Application Pub. No. 2009/0078309 A1 (Cornfeld et al.). More generally, the alpha layer has a different composition than the adjacent layers above and below it. As shown in FIG. 4A, the stepped line to the left depicts the step grading of the in plane lattice constant being incrementally greater from sublayer 505a through sublayer 505z, such sublayers being fully relaxed.

A metamorphic layer (or graded interlayer) 505 is deposited over the alpha layer 504 using a surfactant. Layer 505 is preferably a compositionally step-graded series of p-type InGaAs or InGaAlAs layers, preferably with monotonically changing lattice constant, so as to achieve a gradual transition in lattice constant in the semiconductor structure from fourth subcell D to third subcell C while minimizing threading dislocations from occurring. In one embodiment, the band gap of layer 505 is constant throughout its thickness, preferably approximately equal to 1.22 to 1.34 eV, or otherwise consistent with a value slightly greater than the band gap of the third subcell C. In another embodiment, the band gap of the sublayers of layer 505 vary in the range of 1.22 to 1.34 eV, with the first layer having a relatively high band gap, and subsequent layers incrementally lower band gaps. One embodiment of the graded interlayer may also be expressed as being composed of InₓGa₁₋ₓAs, with 0 < x < 1, 0 < y < 1, and x and y selected such that the band gap of the interlayer remains constant at approximately 1.22 to 1.34 eV or other appropriate band gap.

In one embodiment, aluminum is added to one sublayer to make one particular sublayer harder than another, thereby forcing dislocations in the softer material.

In the surfactant assisted growth of the metamorphic intermediate graded layer 505, a suitable chemical element is introduced into the reactor during the growth of layer 505 to improve the surface characteristics of the layer. In the preferred embodiment, such element may be a dopant or donor atom such as selenium (Se) or tellurium (Te). Small amounts of Se or Te are therefore incorporated in the metamorphic layer 406, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAlAs, in the metamorphic buffer layer. Such Sb or Bi surfactants will not typically be incorporated into the metamorphic layer 505.

In one embodiment of the present disclosure, the metamorphic layer 505 is composed of a plurality of layers of InGaAs, with monotonically changing lattice constant, each layer having a band gap in the range of 1.22 to 1.34 eV. In some embodiments, the band gap is constant in the range of 1.27 to 1.31 eV through the thickness of layer 505. In some embodiments, the constant band gap is in the range of 1.28 to 1.29 eV.

The advantage of utilizing a constant bandgap material such as InGaAs is that arsenide-based semiconductor material is much easier to process in standard commercial MOCVD reactors.

Although the described embodiment of the present disclosure utilizes a plurality of layers of InGaAs for the metamorphic layer 505 for reasons of manufacturability and radiation transparency, other embodiments of the present disclosure may utilize different material systems to achieve a change in lattice constant from third subcell C to fourth subcell D. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter less than or equal to that of the third subcell C and greater than or equal to that of the fourth subcell D. In some embodiments, layer 505 has a band gap energy greater than that of the third subcell C, and in other embodiments has a band gap energy level less than that of the third subcell C.

In some embodiments, a second "alpha" or threading dislocation inhibition layer 507, preferably composed of p type GaInP, is deposited over metamorphic buffer layer 505, to a thickness of from 0.10 to about 1.0 micron. Such an alpha layer is intended to prevent threading dislocations from propagating, either opposite to the direction of growth into the fourth subcell D, or in the direction of growth into the third subcell C, and is more particularly described in U.S. Patent Application Pub. No. 2009/0078309 A1 (Cornfeld et al.).

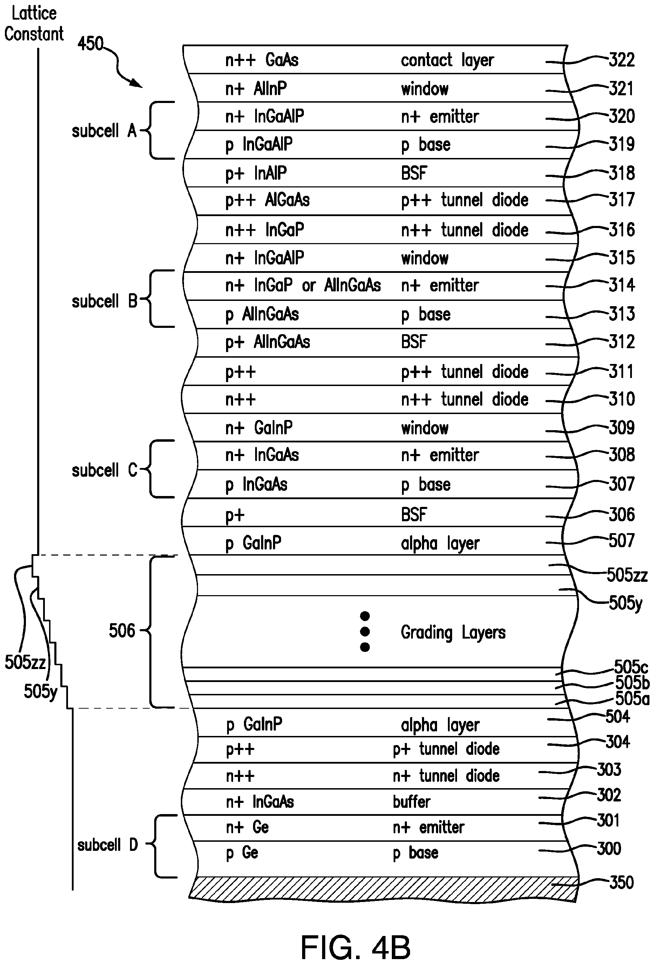

In the embodiment depicted in FIG. 4B, an intermediate graded interlayer 506, comprising in one embodiment step-graded sublayers 505a through 505zz, is disposed over the tunnel diode layer 304. In particular, the graded interlayer provides a transition in lattice constant from the lattice constant of the substrate to the larger lattice constant of the third and upper subcell C, and differs from that of the embodiment of FIG. 4A only in that the top or uppermost sublayer 505zz of the graded interlayer 506 is strained or only partially relaxed (unlike the fully relaxed layers below it) since it has a lattice constant which is greater than that of the layer above it, i.e., the alpha layer 507 (should there be a second alpha layer) or the BSF layer 306. In short, in this embodiment there is an "overshoot" of the grading layers, as depicted on the left hand side of FIG. 4B which shows the step-grading of the lattice constant becoming larger from layer 505a to 505zz.

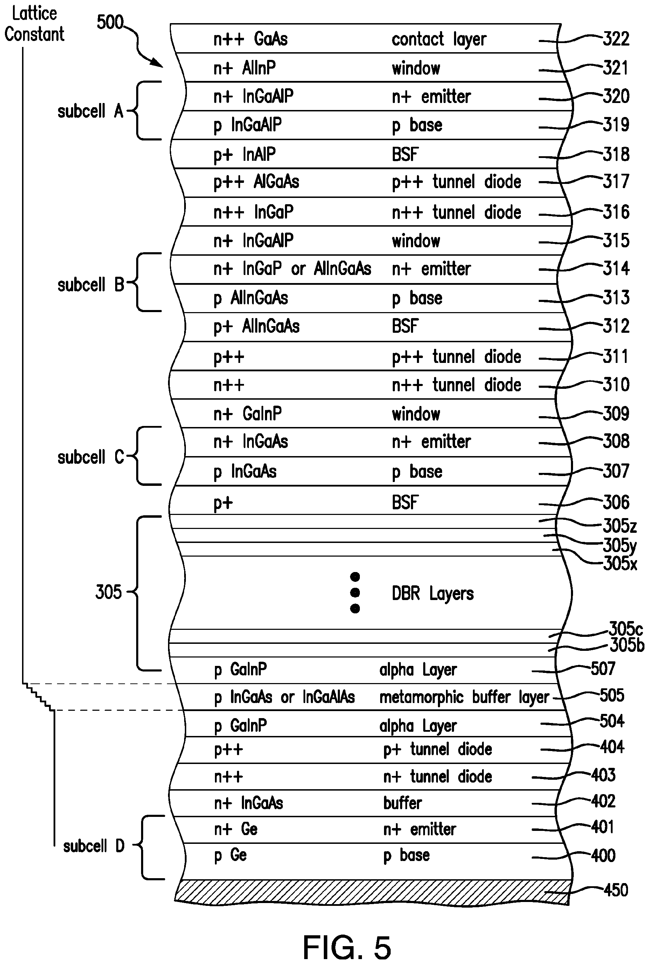

FIG. 5 is a cross-sectional view of a fourth embodiment of a four junction solar cell 500 after several stages of fabrication including the growth of certain semiconductor layers on the growth substrate up to the contact layer 322, with various subcells being similar to the structure described and depicted in FIG. 2, 4A, 4B.

In this embodiment, both an intermediate graded layer and a DBR layer are disposed between third subcell C and fourth subcell D. The layers 450, 400 to 404, 504 to 506 and 306 through 322 are substantially similar to that of FIG. 2 and FIG. 4A or 4B and their description need not be repeated here.

In this embodiment, Distributed Bragg reflector (DBR) layers 305 are then grown adjacent to and over the alpha layer 506 (or the metamorphic buffer layer 505 if layer 506 is not present). The DBR layers 305 are arranged so that light can enter and pass through the third solar subcell C and at least a portion of which can be reflected back into the third subcell C by the DBR layers 305. In the embodiment depicted in FIG. 5, the distributed Bragg reflector (DBR) layers 305 are specifically located between the third subcell C and metamorphic layer 505.

For some embodiments, distributed Bragg reflector (DBR) layers 305 can be composed of a plurality of alternating layers 305a through 305z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 305a through 305z includes a first DBR layer composed of a plurality of p type In_{z}AlₓGa_{1-x-z}As layers, and a second DBR layer disposed over the first DBR layer and composed of a plurality of p type In_{w}Al_{y}Ga_{1-y-w}As layers, where 0 < w < 1, 0 < x < 1, 0 < y < 1, 0 < z < 1 and y is greater than x.

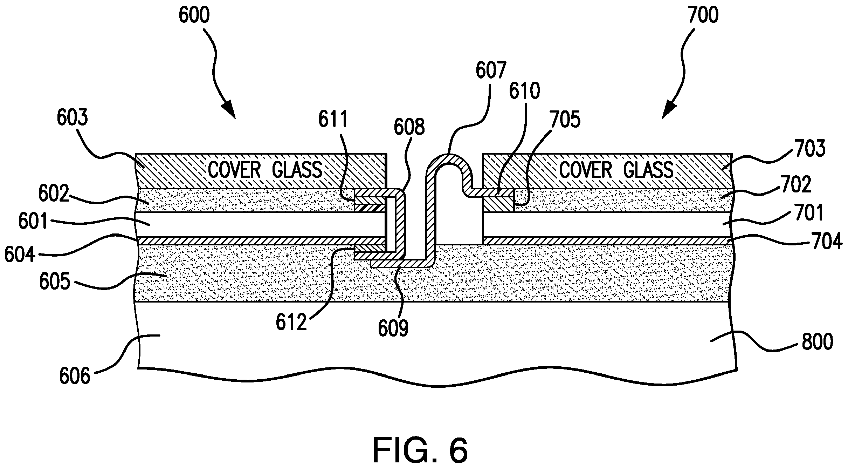

FIG. 6 is a cross-sectional view of a portion of the solar cell assembly according to the present disclosure as mounted on a panel or supporting substrate, with the Figure depicting two adjacent solar cells 601 and 701 and corresponding CICs 600 and 700 respectively.

As previously noted, for space applications, the solar cell 601, 701 includes a coverglass 603, 703 respectively over the semiconductor device to provide radiation resistant shielding from particles in the space environment which could damage the semiconductor material. The cover glass 603, 703 is typically a ceria doped borosilicate glass which is typically from three to six mils in thickness and attached by a transparent adhesive 602, 702 respectively to the corresponding solar cell 601, 701.

Bonding pads of a first and second polarity type are provided on each solar cell. In one embodiment, a back metal 604 and 704 respectively form contacts of a first polarity type. On the top surface of each solar cell, a metal contact 705 is provided along one edge of the solar cell form a contact of the second polarity.

A plurality of electrical interconnects 607 each composed of a strip of silver-plated nickel-cobalt ferrous alloy material are provided, each interconnect being welded to a respective bonding pad 612 and 705 on each solar cell assembly to electrically connect the adjacent solar cell assemblies of the array in a series electrical circuit.

An aluminum honeycomb panel 606 having a carbon composite face sheet 605 with a coefficient of thermal expansion (CTE) that substantially matches the germanium of the fourth solar subcell in each solar cell is provided with each CIC 600, 700 or solar cell assembly mounted thereon.

Another feature of the solar cell assembly in the embodiment illustrated in FIG. 6 is that the cover glasses 603, 703 each have a metal wrap-around clip 608 depicted in CIC 600 which makes contact with the surface of the cover glass 603, and extends down the gap or space along the side of the solar cell assembly 600 between CICs 600 and 700 to make electrical contact with the metal bonding pad 612 on the back surface of CIC 600, which in turn makes contact with electrical ground. Thus, the clip 608 grounds the electrical charge build-up on the surface of the cover glass 603 to the ground of the panel or spacecraft. Other configurations of grounding techniques for the surface(s) of the coverglass 603, 703 are within the scope of this disclosure.

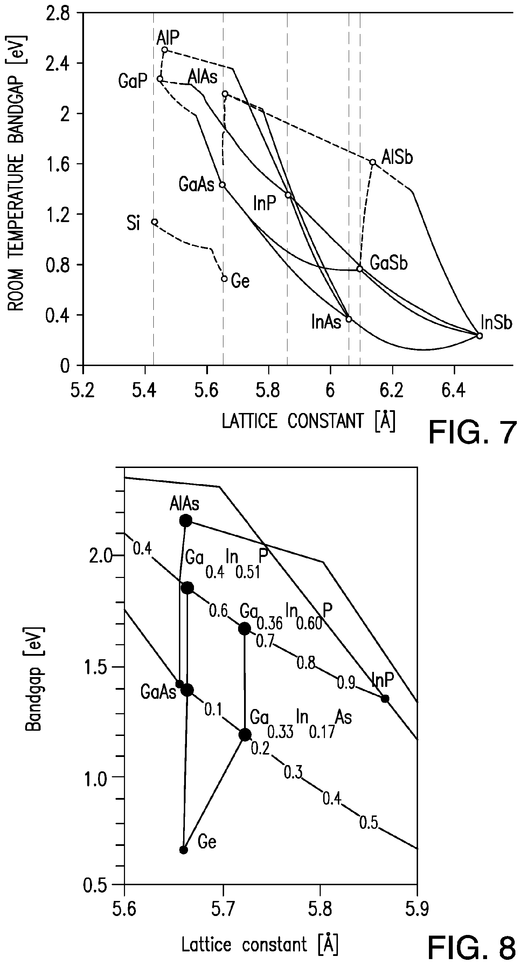

FIG. 7 is a graph representing the band gap of certain binary materials and their lattice constants. The band gap and lattice constants of ternary materials are located on the lines drawn between typical associated binary materials (such as the ternary material AlGaAs being located between the GaAs and AlAs points on the graph, with the band gap of the ternary material lying between 1.42 eV for GaAs and 2.16 eV for AlAs depending upon the relative amount of the individual constituents). Thus, depending upon the desired band gap, the material constituents of ternary materials can be appropriately selected for growth.

FIG. 8 is an enlargement of a portion of the graph of FIG. 7 illustrating different compounds of GaInAs and GaInP with different proportions of gallium and indium, and the location of specific compounds on the graph.

The present disclosure provides a multijunction solar cell that follows a design rule that one should incorporate as many high band gap subcells as possible to achieve the goal to increase the efficiency at high temperature EOL. For example, high band gap subcells may retain a greater percentage of cell voltage as temperature increases, thereby offering lower power loss as temperature increases. As a result, both HT-BOL and HT-EOL performance of the exemplary multijunction solar cell, according to the present disclosure, may be expected to be greater than traditional cells.

For example, the cell efficiency (%) measured at room temperature (RT) 28° C and high temperature (HT) 70° C, at beginning of life (BOL) and end of life (EOL), for a standard three junction commercial solar cell (ZTJ), is shown in Table 1:

**TABLE 1**

| CONDITION | EFFICIENCY |
|---|---|
| BOL 28° C | 29.1% |
| BOL 70° C | 26.4% |
| EOL 70° C | 23.4% After 5E14 e/cm² radiation |
| EOL 70°C | 22.0% After 1E15 e/cm² radiation |

For the solar cell initially described in the parent application, U.S. Patent Application Serial No. 14/828,206 filed August 17, 2015 (and corresponding published European Patent Application EP 3 133 65 A1) the corresponding data is shown in Table 2:

**TABLE 2**

| CONDITION | EFFICIENCY |
|---|---|
| BOL 28° C | 29.1% |
| BOL 70° C | 26.5% |
| EOL 70° C | 24.5% After 5E14 e/cm² radiation |
| EOL 70° C | 23.5% After 1E15 e/cm² radiation |

The solar cell described in the earliest applications of Applicant has a slightly higher cell efficiency than the standard commercial solar cell (ZTJ) at BOL at 70° C. However, the solar cell described in one embodiment of the disclosure exhibits substantially improved cell efficiency (%) over the standard commercial solar cell (ZTJ) at 1 MeV electron equivalent fluence of 5 × 10¹⁴ e/cm², and dramatically improved cell efficiency (%) over the standard commercial solar cell (ZTJ) at 1 MeV electron equivalent fluence of 1 × 10¹⁵ e/cm².

In view of different satellite and space vehicle requirements in terms of operating environmental temperature, radiation exposure, and operational life, a range of subcell designs using the design principles of the present disclosure may be provided satisfying specific defined customer and mission requirements, and several illustrative embodiments are set forth hereunder, along with the computation of their efficiency at the end-of-life for comparison purposes. As described in greater detail below, solar cell performance after radiation exposure is experimentally measured using 1 MeV electron fluence per square centimeter (abbreviated in the text that follows as e/cm²), so that a comparison can be made between the current commercial devices and embodiments of solar cells discussed in the present disclosure.

As an example of different mission requirements, a low earth orbit (LEO) satellite will typically experience radiation equivalent to 5 × 10¹⁴ electron fluence per square centimeter (hereinafter written as "5E14 e/cm²") over a five year lifetime. A geosynchronous earth orbit (GEO) satellite will typically experience radiation in the range of 5 × 10¹⁴ e/cm² to 1 × 10¹⁵ e/cm² over a fifteen year lifetime.

The simplest manner to express the different embodiments of the present disclosure and their efficiency compared to that of the standard solar cell noted above is to list the embodiments with the specification of the composition of each successive subcell and their respective band gap, and then the computed efficiency.

Thus, for a four junction solar cell as configured and described in the present disclosure, four embodiments and their corresponding efficiency data at the end-of-life (EOL) is as follows:

| Embodiment 1 | Band Gap | Composition |
|---|---|---|
| Subcell A | 2.1 | AlInGaP |
| Subcell B | 1.73 | InGaP/AlInGaAs or AlinGaAs/AlInGaAs |
| Subcell C | 1.41 | (In)GaAs |
| Subcell D | 0.67 | Ge |

Efficiency at 70° C after 5E14 e/cm² radiation: 24.5%
Efficiency at 70° C after 1E15 e/cm² radiation: 23.5%

| Embodiment 2 | Band Gap | Composition |
|---|---|---|
| Subcell A | 2.1 | AlInGaP |
| Subcell B | 1.67 | InGaP/AlInGaAs or AlinGaAs/AlInGaAs |
| Subcell C | 1.34 | InGaAs |
| Subcell D | 0.67 | Ge |

Efficiency at 70° C after 1E15 e/cm² radiation: 24.9%

| Embodiment 3 | Band Gap | Composition |
|---|---|---|
| Subcell A | 2.1 | AlInGaP |
| Subcell B | 1.65 | InGaP/AlInGaAs or AlinGaAs/AlInGaAs |
| | | |
| Subcell C | 1.30 | (In)GaAs |
| Subcell D | 0.67 | Ge |

Efficiency at 70° C after 1E15 e/cm² radiation: 25.3%

| Embodiment 4 | Band Gap | Composition |
|---|---|---|
| Subcell A | 2.03 | AlInGaP |
| Subcell B | 1.55 | InGaP/AlInGaAs or AlinGaAs/AlInGaAs |
| | | |
| Subcell C | 1.2 | (In)GaAs |
| Subcell D | 0.67 | Ge |

Efficiency at 70° C after 1E15 e/cm2 radiation: 25.7%

Although the differences in band gap among the various embodiments described above, i.e., of the order of 0.1 to 0.2 eV, may seem relatively small, such adjustments result in a surprising and unexpected increase in the EOL solar cell efficiency from 24.4% as reported in the parent application U.S. Patent Application Serial No. 14/828,206 filed August 17, 2015 (and corresponding published European Patent Application EP 3 133 650 A1) to 25.7% for the solar cell of embodiment 4 described above, such surprising and unexpected improvement resulting from the relatively small change in band gap implies a significant inventive step over the related configuration described in the parent application and European patent application publication sonce in the field of solar cell devices for space applications even small improvements in efficiency are typically considered important.

The exemplary solar cell described herein may require the use of aluminum in the semiconductor composition of each of the top two subcells. Aluminum incorporation is widely known in the III-V compound semiconductor industry to degrade BOL subcell performance due to deep level donor defects, higher doping compensation, shorter minority carrier lifetimes, and lower cell voltage and an increased BOL E_{g}/q - V_{oc} metric. In short, increased BOL E_{g}/q - V_{oc} may be the most problematic shortcoming of aluminum containing subcells; the other limitations can be mitigated by modifying the doping schedule or thinning base thicknesses.

It will be understood that each of the elements described above, or two or more together, also may find a useful application in other types of structures or constructions differing from the types of structures or constructions described above.

Although described embodiments of the present disclosure utilizes a vertical stack of four subcells, various aspects and features of the present disclosure can apply to stacks with fewer or greater number of subcells, i.e. two junction cells, three junction cells, five, six, seven junction cells, etc.

### EXAMPLES

Example 1. A method for fabricating a four-junction space-qualified solar cell (200, 400, 450, 500) designed for operation at AM0 and at a 1 MeV electron equivalent fluence of at least 1 x 10¹⁴ e/cm², the solar cell comprising solar subcells (A,B,C,D), comprising the following steps: providing a semiconductor growth substrate (300); forming a fourth solar subcell (D) over or in the growth substrate (300); growing a sequence of layers of semiconductor material using a deposition process to form a solar cell comprising a plurality of solar subcells including a third solar subcell (C) disposed over the fourth solar subcell (D) and being lattice mis-matched from the fourth solar subcell (D), a second solar subcell (B) disposed over and lattice matched to the third solar subcell (C) and having a band gap in the range of approximately 1.55 to 1.8 eV and an upper first solar subcell (A) disposed over and lattice matched to the second solar subcell (B) and having a band gap in the range of 2.0 to 2.2 eV, wherein the average band gap of all four solar subcells is greater than 1.35 eV.

Example 2. The method of Example 1, wherein the upper first solar subcell (A) has a band gap of less than 2.15, the second solar subcell (B) has a band gap of less than 1.73 eV; and the third solar subcell (C) has a band gap in the range of 1.15 to 1.2 eV.

Example 3. The method of Example 1, wherein the upper first solar subcell (A) has a band gap of 2.05 eV.

Example 4. The method of Example 1, wherein the band gap of the third solar subcell (C) is less than 1.41 eV, and greater than that of the fourth solar subcell (D).

Example 5. The method of Example 1, wherein the upper first solar subcell (A) is composed of a base layer (319) of (InₓGa₁₋ₓ)_{1-y}Al_{y}P where x is 0.505, and y is 0.142, corresponding to a band gap of 2.10 eV, and an emitter layer (320) of (InₓGa₁₋ₓ)_{-y}Al_{y}P where x is 0.505, and y is 0.107, corresponding to a band gap of 2.05 eV.

Example 6. The method of Example 1, further providing an intermediate graded layer (505) disposed between the third solar subcell (C) and the fourth solar subcell (D) wherein the intermediate graded layer (505) is compositionally graded to lattice match the third solar subcell (C) on one side and the fourth solar subcell (D) on the other side and is composed of any of the As, P, N, Sb based III-V compound semiconductors subject to the constraints of having the in-plane lattice parameter greater than or equal to that of the fourth solar subcell (D) and less than or equal to that of the lower third solar subcell (C), and having a band gap energy greater than that of the third solar subcell (C).

Example 7. The method of Example 1, further providing an intermediate graded layer (505) disposed between the third solar subcell (C) and the fourth solar subcell (D) wherein the intermediate graded layer (505) is compositionally step-graded with between one and four steps to lattice match the third solar subcell (C) on one side and composed of InGaAs or (InₓGa₁₋ₓ)_{y}Al_{1-y} As with 0 < x < 1, 0 < y < 1, and x and y selected such that the band gap remains in the range of 1.15 to 1.41 eV throughout its thickness.

Example 8. The method of Example 6, wherein the intermediate graded layer (505) has a band gap in the range of 1.15 to 1.41 eV, or 1.2 to 1.35 eV, or 1.25 to 1.30 eV.

Example 9. The method of Example 1, wherein either (i) the emitter layer (320); or (ii) the base layer (319) and emitter layer (320), of the upper first solar subcell (A) have different lattice constants from the lattice constant of the second solar subcell (B).

Example 10. The method of Example 1, further providing: a distributed Bragg reflector (DBR) layer (305) adjacent to and beneath the third solar subcell (C) and arranged so that light can enter and pass through the third solar subcell (C) and at least a portion of which can be reflected back into the third solar subcell (C) by the DBR layer, wherein the distributed Bragg reflector layer (305) is composed of a plurality of alternating layers of lattice matched materials with discontinuities in their respective indices of refraction, wherein the difference in refractive indices between alternating layers is maximized in order to minimize the number of periods required to achieve a given reflectivity, and the thickness and refractive index of each period determines the stop band and its limiting wavelength, and wherein the DBR layer (305) includes a first DBR layer composed of a plurality of p type AlₓGa₁₋ₓAs sublayers, and a second DBR layer disposed over the first DBR layer and composed of a plurality of p type Al_{y}Ga_{1-y}As sublayers, where 0 < x < 1, 0 <y < 1, and y is greater than x so that the first and second DBR layers are compositionally different.; and an intermediate graded layer (505) disposed between the DBR layer (305) and the fourth solar subcell (D), wherein the intermediate graded layer is compositionally step-graded to lattice match the DBR layer (305) on one side and the fourth solar subcell (D) on the other side, and is composed of any of the As, P, N, Sb based III-V compound semiconductors subject to the constraints of having the in-plane lattice parameter less than or equal to that of the DBR layer (305) and greater than or equal to that of the fourth solar subcell (D).

Example 11. The method of Example 1, wherein each solar subcell (A,B,C) includes an emitter region (320, 314,308) and a base region (319,313, 307), and one or more of the solar subcells have a base region having a gradation in doping that increases exponentially from 1 × 10¹⁵ atoms per cubic centimeter adjacent the p-n junction to 4 × 10¹⁸ atoms per cubic centimeter adjacent to the adjoining layer at the rear of the base, and an emitter region having a gradation in doping that decreases from approximately 5 × 10¹⁸ per cubic centimeter in the region immediately adjacent the adjoining layer to 5 × 10¹⁷ per cubic centimeter in the region adjacent to the p-n junction.

Example 12. The method of Example 6, wherein the intermediate graded layer (505) is compositionally graded such that sublayers (505a, ..., 505zz) are defined having step-graded lattice constants, wherein at least one of the upper sublayers (505zz) of the intermediate graded layer (505) has a larger lattice constant than the adjacent layers (506, 306) to the upper sublayer disposed above the intermediate graded layer.

Example 13. The method of Example 1, wherein the difference in lattice constant between the adjacent third (C) and fourth (D) solar subcells is in the range of 0.1 to 0.2 Angstroms.

Example 14. The method of Example 1, further comprising a first threading dislocation inhibition layer (504) having a thickness in the range of 0.1 to 1.0 microns and disposed over said fourth solar subcell (D).

Example 15. The method of Example 14, further providing a second threading dislocation inhibition layer (506) having a thickness in the range of 0.1 to 1.0 micron and composed of InGa(Al)P, the second threading dislocation inhibition layer (506) being disposed over and directly adjacent to said intermediate graded layer (505) for reducing the propagation of threading dislocations, said second threading dislocation inhibition layer (506) having a composition different from a composition of the first threading dislocation inhibition layer (504).

## Claims

1. A four-junction space-qualified solar cell (200, 400, 450, 500) designed for operation at AM0 and at a 1 MeV electron equivalent fluence of at least 1 × 10¹⁴ e/cm², wherein a combination of compositions and band gaps of the subcells is designed to maximize efficiency of the solar cell at a predetermined time after initial deployment when the solar cell is deployed in space at AM0 and at an operational temperature in the range of 40 to 70 degree Centigrade, the predetermined time being at least five years and referred to as the End of Life, EOL, the solar cell comprising:
a semiconductor growth substrate (300);
a plurality of solar subcells including a fourth solar subcell (D) formed over or in the growth substrate (300),
a third solar subcell (C) disposed over the fourth solar subcell (D) and being lattice mis-matched from the fourth solar subcell (D), a second solar subcell (B) disposed over and lattice matched to the third solar subcell (C) and having a band gap in the range of approximately 1.55 to 1.8 eV and an upper first solar subcell (A) disposed over and lattice matched to the second solar subcell (B) and having a band gap in the range of 2.0 to 2.2 eV, wherein the average band gap of all four solar subcells is greater than 1.35 eV, wherein the band gap of the third solar subcell (C) is less than 1.41 eV, and greater than that of the fourth solar subcell (D);
an intermediate graded layer (506) disposed between the third solar subcell (C) and the fourth solar subcell (D), wherein the intermediate graded layer (506) is compositionally graded to lattice match the third solar subcell (C) on one side and the fourth solar subcell (D) on the other side and is composed of any of the As, P, N, Sb based III-V compound semiconductors subject to the constraints of having the in-plane lattice parameter greater than or equal to that of the fourth solar subcell (D), and having a band gap energy greater than that of the third solar subcell (C),
wherein the intermediate graded layer (506) is compositionally graded such that sublayers (505a, ...505zz) are defined having step-graded lattice constants, wherein an uppermost sublayer (505zz) of the intermediate graded layer (506) has a larger lattice constant than an adjacent layer (507) adjacent to and disposed above the uppermost sublayer (505zz) and a back surface field layer (306) adjacent to and disposed above the adjacent layer (507) ,
**characterized in that** the adjacent layer (507) has a different composition than the uppermost sublayer (505zz) and the back surface field layer (306),
and **in that** the adjacent layer (507) has the same lattice constant as the back surface field layer (306).

2. The solar cell as defined in claim 1, wherein the intermediate graded layer is a p-type InGaAl or InGaAlAs layer.

3. The solar cell as defined in claim 1, wherein the band gap of the sublayers of intermediate graded layer vary in the range of 1.22-1.34eV, preferably 1.27-1.31eV, more preferably 1.28-1.29eV, with the first layer having a relatively high bandgap, and the subsequent layers incrementally lower band gaps.

4. The solar cell as defined in claim 3, wherein aluminum is added to one sublayer to make one particular sublayer harder than another, thereby forcing dislocations in the softer material.

5. The solar cell as defined in claim 1, wherein the solar cell further comprises selenium or tellurium.

6. The solar cell as defined in claim 1, wherein the upper first solar subcell (A) has a band gap of less than 2.15, the second solar subcell (B) has a band gap of less than 1.73 eV; and the third solar subcell (C) has a band gap in the range of 1.15 to 1.2 eV.

7. The solar cell as defined in claim 1, wherein the upper first solar subcell (A) has a band gap of 2.05 eV.

8. The method as defined in claim 1, wherein the upper first solar subcell (A) is composed of a base layer (319) of (InₓGa₁₋ₓ)_{1-y}Al_{y}P where x is 0.505, and y is 0.142, corresponding to a band gap of 2.10 eV, and an emitter layer (320) of (InₓGa₁₋ₓ)_{1-y}Al_{y}P where x is 0.505, and y is 0.107, corresponding to a band gap of 2.05 eV.

9. The solar cell as defined in claim 1, wherein each solar subcell (A, B, C) includes an emitter region (320, 314,308) and a base region (319,313, 307), and one or more of the solar subcells have a base region having a gradation in doping that increases exponentially from 1 × 10¹⁶ atoms per cubic centimeter adjacent the p-n junction to 4 × 10¹⁸ atoms per cubic centimeter adjacent to the adjoining layer at the rear of the base, and an emitter region having a gradation in doping that decreases from approximately 5 × 10¹⁸ per cubic centimeter in the region immediately adjacent the adjoining layer to 5 × 10¹⁷ per cubic centimeter in the region adjacent to the p-n junction.

10. The solar cell as defined in claim 1, wherein the difference in lattice constant between the adjacent third (C) and fourth (D) solar subcells is in the range of 0.1 to 0.2 Angstroms.

11. The solar cell as defined in claim 1, further comprising a first threading dislocation inhibition layer (504) having a thickness in the range of 0.1 to 1.0 microns and disposed over said fourth solar subcell (D).

12. The solar cell as defined in claim 11, further comprising a second threading dislocation inhibition layer (506) having a thickness in the range of 0.1 to 1.0 micron and composed of InGa(Al)P, the second threading dislocation inhibition layer (506) being disposed over and directly adjacent to said intermediate graded layer (505) for reducing the propagation of threading dislocations, said second threading dislocation inhibition layer (506) having a composition different from a composition of the first threading dislocation inhibition layer (504).

13. The solar cell as defined in claim 11, further comprising a second threading dislocation inhibition layer comprising p type GaInP deposited over the intermediated graded layer.
